# EUROPÄISCHE PATENTSCHRIFT

(11) **EP 0 904 161 B1**
(45) Veröffentlichungstag und Bekanntmachung des Hinweises auf die Patenterteilung: **22.12.1999**
(21) Anmeldenummer: 97926977.6
(22) Anmeldetag: 04.06.1997
(51) Int. Cl.: B06B 1/06

(54) **ULTRASCHALLWANDLER**
ULTRASONIC TRANSDUCER
TRANSDUCTEUR ULTRASONIQUE

(30) Priorität: 10.06.1996 DE 19623071
(43) Veröffentlichungstag der Anmeldung: 31.03.1999
(73) Patentinhaber: SIEMENS AKTIENGESELLSCHAFT, 80333 München (DE)
(72) Erfinder: THURN, Rudolf, D-92690 Pressath (DE)
(86) Internationale Anmeldenummer: DE9701125
(87) Internationale Veröffentlichungsnummer: WO9747403

(56) Entgegenhaltungen:
- EP-A- 0 390 959
- DE-A- 3 842 759
- DE-C- 4 233 256
- "plastic disk makes transducer excel in calculating distances by ultrasound" ELECTRONICS INTERNATIONAL, Bd. 51, Nr. 11, 25.Mai 1978, Seiten 76-78, XP002040682
- VASIL'EV P.E. ET AL.: "sectional radial-mode piezoelectric transducer" SOVIET PHYSICS ACOUSTICS, Bd. 26, Nr. 4, 1.August 1980, XP002040684
- KLEINSCHMIDT P., MAGORI V.: "ultrasonic remote sensors for noncontact object detection" SIEMENS FORSCH.- UND ENTWICKL.-BER, Bd. 10, Nr. 2, 1981, Seiten 110-118, XP002040683

## Beschreibung

Die Erfindung bezieht sich auf einen Ultraschallwandler mit einer Piezokeramikscheibe in Radialresonanzbetrieb und mit einem Ring, der die Piezokeramikscheibe an ihrer Mantelfläche form- und kraftschlüssig umschließt.

Gattungsgemäße Ultraschallwandler sind durch zahlreiche Veröffentlichungen bekannt. In vielen Anwendungsfällen, z.B. bei Ultraschallsensoren bzw. Näherungsschaltern werden Ultraschallwandler benötigt, die eine sehr schmale Schallkeulencharakteristik aufweisen und zugleich sehr kleine Nebenkeulenamplituden haben.

Aus der DE 25 41 492 C2 ist ein recht scharfer Ultraschallwandler in Saturngeometrie bekannt, der bei Ultraschallsensoren im industriellen Einsatz weit verbreitet ist. Er ist aufgebaut aus einer Piezokeramikscheibe, einer Anpaßschichtscheibe und einem konzentrischen Metallring. Durch einen weiten Überstand der Anpaßschichtscheibe über den Durchmesser der Piezokeramikscheibe ist die Fläche der Anpaßschicht groß, wodurch ein sehr schmaler Öffnungswinkel ϕ der Schallkeule von 5° erzielt wird. Durch den großen Überstand der Anpaßschichtscheibe ist es schwierig, die günstige Schwingungsamplitudenverteilung und Phasenlage über der gesamten Fläche in der Praxis immer exakt einzuhalten, so daß es zu problematischen seitlichen Nebenkeulen kommt.

Aus der DE 42 33 255 C1 ist ein Ultraschallwandler mit runder Piezokeramikscheibe in Radialresonanz bekannt, der bei gegebenen Abmessungen der Piezokeramikscheibe eine gegenüber der Radialresonanzfrequenz der Piezokeramikscheibe verringerte Betriebsfrequenz aufweist. Dies wird durch einen Metallring erreicht, der die Piezokeramikscheibe form- und kraftschlüssig umschließt und vorzugsweise auf die Piezokeramikscheibe aufgeschrumpft ist. Der aus der Piezokeramikscheibe und dem Metallring bestehende Verbundkörper bildet einen Radialschwinger, der sich hinsichtlich seiner Schwingungseigenschaften wie ein Piezokörper mit größerem Durchmesser und mit verringerter Frequenz verhält. Durch entsprechende Bemessung des Metallrings kann die Betriebsfrequenz unterschiedlich stark verringert werden. An die Stirnfläche des Verbundkörpers ist eine Anpaßschicht angebracht.

Im Dokument Siemens Forschungs- und Entwicklungsberichte, Band 10, Nr. 2, 1981, Seiten 110 bis 118, ist ein Ultraschallwandler der oben beschriebenen Art mit einem Ring aus Aluminium offenbart.

Der Erfindung liegt die Aufgabe zugrunde, einen Ultraschallwandler der obengenannten Art mit hinsichtlich dem Hauptkeulenöffnungswinkel und der Unterdrückung von Nebenkeulen verbesserten Abstrahleigenschaften zu schaffen und insbesondere einen möglichst schmalen Hauptkeulenöffnungswinkel zu erhalten.

Die Aufgabe wird erfindungsgemäß dadurch gelöst, daß der Ring aus einem Material besteht, dessen Schallgeschwindigkeit höher ist als die von Aluminium. Dadurch verringert sich die resultierende Radialresonanzfrequenz des Verbundkörpers aus Piezokeramikscheibe und Ring entweder weniger als bei Aluminium, bleibt gleich oder wird in definierter Weise deutlich höher als die ursprüngliche Radialresonanzfrequenz der Piezokeramikscheibe, trotz größerem Durchmesser. Als Konsequenz erhöht sich für den Verbundkörper, dessen Stirnfläche in der Regel ungefähr gleich groß wie die Schallabstrahlfläche ist, das Verhältnis aus Durchmesser der Schallabstrahlfläche und Wellenlänge der abgestrahlten Ultraschallwelle, die umgekehrt proportional zur Radialresonanzfrequenz ist. Dadurch können bei dem erfindungsgemäßen Ultraschallwandler -3 dB Öffnungswinkel der Schallkeule bis unter 5° erreicht werden bei Nebenkeulendämpfungen von ca. -30 dB gegenüber der Hauptkeulenamplitude. Die Haupteinflußgröße ist dabei die Longitudinalwellengeschwindigkeit des Ringmaterials, während durch die Variation der geometrischen Abmessungen des Rings in sinnvoller und praktikabler Größenordnung die Radialresonanzfrequenz nur in vergleichsweise engen Grenzen eingestellt werden kann.

Vorteilhafte Ausführungsformen der Erfindung sind den Unteransprüchen 2 bis 6 zu entnehmen.

Ein Ausführungsbeispiel der Erfindung wird im folgenden anhand einer Zeichnung näher erläutert.

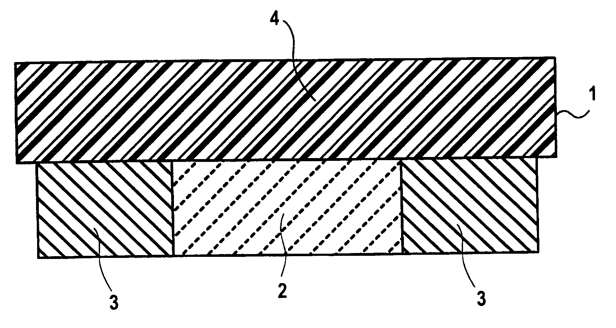

Die Zeichnung zeigt ein Schnittbild des erfindungsgemäßen Ultraschallwandlers 1. Er ist im wesentlichen aus einer zylindrischen Piezokeramikscheibe 2, einem Ring 3 und einer Anpaßschicht 4 zusammengesetzt. Der Ring 3 umschließt die Piezokeramikscheibe 2 an ihrer Mantelfläche form- und kraftschlüssig, wobei die Verbindung vorzugsweise durch Verklebung hergestellt wird. Die eine Fläche dieses Verbundkörpers ist mit der Anpaßschicht 4 versehen, deren Durchmesser etwa gleich dem Außendurchmesser des Rings entspricht und deren Dicke etwa einer Viertelwellenlänge der erzeugten Ultraschallwelle entspricht. Für die Ankopplung des Wellenwiderstandes an Luft verwendet man für die Anpaßschicht 4 vorzugsweise syntaktische Schaumwerkstoffe aus Kunstharz mit Glasklugeln oder gummiartige Stoffe, wie z.B. Silikone. Durch die Anpaßschicht wird erreicht, daß die Ultraschallwelle im wesentlichen nur auf der freien Stirnseite der Anpaßschicht 4 abgestrahlt wird. Die erfinderische Ausprägung besteht in der Verwendung eines Materials für den Ring 3, dessen Longitudinalwellengeschwindigkeit höher ist als die von Aluminium. Man erhält auf diese Weise eine gegenüber der Piezokeramikscheibe 2 höhere effektive Longitudinalwellengeschwindigkeit des Verbundkörpers, so daß sich auch eine erhöhte resultierende Resonanzfrequenz der Radialschwingungsmode des Verbundkörpers ergibt, was sich auf die Abstrahleigenschaften des Ultraschallwandlers 1 günstig auswirkt. Denn hierdurch wird das Verhältnis von Abstrahlfläche zur Wellenlänge der Ultraschallwelle größer und damit der Schallkeulenöffnungswinkel in gewünschter Weise schmäler. Neben der Longitudinalwellengeschwindigkeit des Rings 3 ist dieser Effekt auch um so stärker je größer der volumenmäßige Anteil des Rings 3 am Gesamtvolumen des Verbunds aus der Piezokeramikscheibe 2 und dem Ring 3 ist. Dies bedeutet, daß sich mit größerem Verhältnis von Außendurchmesser des Rings zu Durchmesser der Piezokeramikscheibe 2 ein größeres Verhältnis von Abstrahlfläche zu Wellenlänge ergibt. Untersuchungen ergaben besonders gute Wandlereigenschaften für Durchmesserverhältnisse im Bereich von etwa 1,05 bis 3.

Als Material mit hoher Longitudinalwellengeschwindigkeit für den Ring 3 kommen unter anderem Werkstoffe wie Silizium, Siliziumdioxid, Siliziumnitrid, Siliziumkarbid oder auch Aluminiumoxid in Frage. Als metallischer Werkstoff eignet sich besonders Beryllium, dessen Longitudinalwellengeschwindigkeitswert bei ca. 12.600 m/sek liegt. Bestimmte Metalle wie Titan, spezielle Stahllegierungen, Nickellegierungen wie Inconel usw. haben ebenso hohe Longitudinalwellengeschwindigkeiten. Eine weitere Werkstoffeigenschaft des Rings 3 ist seine mechanische Schwinggüte. Eine hohe Schwinggüte ist für Wandler mit hoher akustischer Empfindlichkeit erforderlich. Für breitbandige Wandler verwendet man dagegen Werkstoffe mit niedriger Schwinggüte. Zum Beispiel kann die Piezokeramikscheibe 2 aus Bleizirkonat-Titanat und der Ring 3 aus keramischem Aluminiumoxid bestehen, wofür man bei einem Durchmesserverhältnis von Außendurchmesser des Rings 3 zum Durchmesser der Piezokeramikscheibe 2 von etwa 2 einen Schallkeulenöffnungswinkel von ca. 5° (Vollwinkel bei -3 dB Schalldruckabfall) erreicht. Die Nebenkeulendämpfung ist dabei besser als -30 dB.

Eine vorteilhafte Ausführungsform der Erfindung erhält man, wenn die seitliche Mantelfläche der Anpaßschichtscheibe mit einer angepaßten Kontur versehen wird, die z.B. aus mindestens einer Einbuchtung und/oder Ausbuchtung besteht, die beispielsweise einen runden, dreieckförmigen, rechteckförmigen oder trapezförmigen Querschnitt aufweist. Die angepaßte Kontur kann einfach auch darin bestehen, daß die seitliche Mantelfläche der Anpaßschichtscheibe im Querschnitt von schräger Form mit geradlinigem oder gebogenem Verlauf ist, so daß die äußere und die innere Grundfläche der Anpaßschicht unterschiedliche Größe haben. Eine angepaßte Kontur kann sich auch auf der inneren Grundfläche der Anpaßschicht befinden, die hier z.B. die Form von konzentrischen Rillen aufweist. Mit diesen zusätzlichen Maßnahmen können gewünschte Wandlereigenschaften wie z.B. bestimmte anwendungsangepaßte Schallkeulenformen in gezielter Weise eingestellt werden.

Obwohl die vorliegende Erfindung unter Bezugnahme auf die in der beigefügten Zeichnung dargestellte Ausführungsforn erläutert ist, sollte berücksichtigt werden, daß damit nicht beabsichtigt ist, die Erfindung nur auf die dargestellte Ausführungsform zu beschränken, sondern alle möglichen Änderungen, Modifizierungen und äquivalente Anordnungen, soweit sie vom Inhalt der Patentansprüche gedeckt sind, einzuschließen.

## Patentansprüche

1. Ultraschallwandler (1) mit einer Piezokeramikscheibe (2) in Radialresonanzbetrieb, mit einer scheibenförmigen Anpaßschicht (4) und mit einem Ring (3), der die Piezokeramikscheibe (2) an ihrer Mantelfläche form- und kraftschlüssig umschließt, **dadurch gekennzeichnet**, daß der Ring (3) aus einem Material besteht, dessen Longitudinalwellengeschwindigkeit höher als die von Aluminium ist.

2. Ultraschallwandler (1) nach Anspruch 1, **dadurch gekennzeichnet**, daß der Ring (3) aus einem keramischen Material besteht.

3. Ultraschallwandler (1) nach Anspruch 1 oder 2, **dadurch gekennzeichnet**, daß die Schallgeschwindigkeit des Rings (3) nicht unterhalb der Longitudinalwellengeschwindigkeit von Aluminiunoxid liegt.

4. Ultraschallwandler (1) nach Anspruch 1, **dadurch gekennzeichnet**, daß der Ring (3) aus Metall besteht.

5. Ultraschallwandler (1) nach einem der vorangehenden Ansprüche, **dadurch gekennzeichnet**, daß die Verbindung zwischen dem Ring (3) und der Piezokeramikscheibe (2) durch Verklebung besteht.

6. Ultraschallwandler (1) nach einem der vorangehenden Ansprüche, **dadurch gekennzeichnet**, daß das Verhältnis von Außen- zu Innendurchmesser des Rings (3) im Bereich zwischen 1,05 und 3 liegt.

7. Ultraschallwandler (1) nach einem der vorangehenden Ansprüche, **dadurch gekennzeichnet**, daß die scheibenförmige Anpaßschicht (4) auf ihrer Mantelfläche und/oder auf ihrer inneren Grundfläche mit einer angepaßten Kontur versehen ist.

## Claims

1. Ultrasonic transducer (1) having a piezoceramic disc (2) in radial resonance operation, a disc-shaped adapting layer (4), and a ring (3) surrounding the piezoceramic disc (2) on its lateral surface with a form fit and frictional engagement, characterised in that the ring (3) is made of a material whose longitudinal wave velocity is higher than that of aluminium.

2. Ultrasonic transducer (1) according to claim 1, characterised in that the ring (3) is made of a ceramic material.

3. Ultrasonic transducer (1) according to claim 1 or 2, characterised in that the velocity of sound in the ring (3) is not lower than the longitudinal wave velocity of aluminium oxide.

4. Ultrasonic transducer (1) according to claim 1, characterised in that the ring (3) is made of metal.

5. Ultrasonic transducer (1) according to one of the preceding claims, characterised in that the bond between the ring (3) and the piezoceramic disc (2) is established by gluing.

6. Ultrasonic transducer (1) according to one of the preceding claims, characterised in that the ratio of the outside diameter to the inside diameter of the ring (3) is in the range between 1.05 and 3.

7. Ultrasonic transducer (1) according to one of the preceding claims, characterised in that the disc-shaped adapting layer (4) has an adapted contour on its lateral surface and/or on its inside base face.

## Revendications

1. Transducteur (1) à ultrason, comprenant un disque (2) en céramique piézo-électrique à fonctionnement à résonance radiale, une couche (4) d'adaptation en forme de disque et un anneau (3) qui enserre avec complémentarité de forme la surface latérale du disque (2) en céramique piézo-électrique, caractérisé en ce que l'anneau est en un matériau dans lequel la vitesse des ondes longitudinales est supérieure à celle dans l'aluminium.

2. Transducteur (1) à ultrason suivant la revendication 1, caractérisé en ce que l'anneau (3) est en un matériau céramique.

3. Transducteur (1) à ultrason suivant la revendication 1 ou 2, caractérisé en ce que la vitesse du son dans l'anneau (3) n'est pas inférieure à la vitesse des ondes longitudinales dans l'oxyde d'aluminium.

4. Transducteur (1) à ultrason suivant la revendication 1, caractérisé en ce que l'anneau (3) est en métal.

5. Transducteur (1) à ultrason suivant l'une des revendications précédentes, caractérisé en ce que la liaison de l'anneau (3) et le disque (2) en céramique piézo-électrique est obtenue par collage.

6. Transducteur (1) à ultrason suivant l'une des revendications précédentes, caractérisé en ce que le rapport du diamètre extérieur au diamètre intérieur de l'anneau (3) est de l'ordre de 1,05 à 3.

7. Transducteur (1) à ultrason suivant l'une des revendications précédentes, caractérisé en ce que la couche (4) d'adaptation en forme de disque est munie sur sa surface latérale et/ou sur sa surface de base intérieure d'un contour adapté.
